# EUROPÄISCHE PATENTSCHRIFT

(11) **EP 2 335 301 B1**
(45) Veröffentlichungstag und Bekanntmachung des Hinweises auf die Patenterteilung: **04.12.2019**
(21) Anmeldenummer: 09818669.5
(22) Anmeldetag: 06.10.2009
(51) Int. Cl.: H01L 51/50

(54) **STRAHLUNGSEMITTIERENDE VORRICHTUNG**
RADIATION EMITTING DEVICE
DISPOSITIF EMETTEUR DE RAYONNEMENT

(30) Priorität: 07.10.2008 DE 102008050331; 18.12.2008 DE 102008063589
(43) Veröffentlichungstag der Anmeldung: 22.06.2011
(73) Patentinhaber: OSRAM OLED GmbH, 93049 Regensburg (DE)
(72) Erfinder: HUNZE, Arvid, 91056 Erlangen (DE); CHIU, Chien-Shu, Da'an District, Taipei City 106 (TW); KRAUSE, Ralf, 91058 Erlangen (DE); STEINBACHER, Frank, 90459 Nürnberg (DE)
(74) Vertreter: Epping - Hermann - Fischer
(86) Internationale Anmeldenummer: PCT/IB2009/008047
(87) Internationale Veröffentlichungsnummer: WO 2010/046788

(56) Entgegenhaltungen:
- EP-A1- 2 329 544
- WO-A1-2010/028262
- JP-A- 2006 041 395
- US-A1- 2004 137 267
- US-A1- 2005 074 630
- US-A1- 2006 232 194
- US-A1- 2008 103 308
- CHENG GANG ET AL: "Improved efficiency for white organic light-emitting devices based on phosphor sensitized fluorescence" APPLIED PHYSICS LETTERS, AIP, AMERICAN INSTITUTE OF PHYSICS, MELVILLE, NY, US LNKD- DOI:10.1063/1.2178478, Bd. 88, Nr. 8, 24. Februar 2006 (2006-02-24), Seiten 83512-083512, XP012083026 ISSN: 0003-6951
- JEONG-IK LEE ET AL: "White light emitting electrophosphorescent devices with solution processed emission layer" JAPANESE JOURNAL OF APPLIED PHYSICS, JAPAN SOCIETY OF APPLIED PHYSICS, JP LNKD- DOI:10.1143/JJAP.45.9231, Bd. 45, Nr. 12, 1. Dezember 2006 (2006-12-01), Seiten 9231-9233, XP001516462 ISSN: 0021-4922
- ZHANG YINGFANG ET AL: "White organic light-emitting devices based on 4,4'-bis(2,2'-diphenyl vinyl)-1,1'-biphenyl and phosphorescence sensitized 5,6,11,12-tetraphenylnaphthacene" APPLIED PHYSICS LETTERS, AIP, AMERICAN INSTITUTE OF PHYSICS, MELVILLE, NY, US LNKD- DOI:10.1063/1.1845593, Bd. 86, Nr. 1, 22. Dezember 2004 (2004-12-22), Seiten 11112-011112, XP012064400 ISSN: 0003-6951

## Beschreibung

Die vorliegende Erfindung betrifft eine strahlungsemittierende Vorrichtung, gemäß Anspruch 1, mit einer Emitterschicht, die ein Matrixmaterial, einen strahlungsemittierenden Emitter und einen phosphoreszenten Exzitonenfänger enthält.

Diese Patentanmeldung beansprucht die Prioritäten der deutschen Patentanmeldung DE 10 2008 063 589.8 und der deutschen Patentanmeldung DE 10 2008 050 331.2.

Die Druckschrift US 2005/074630 A1, die Druckschrift US 2004/137267 A1 und die die Druckschrift JP 2006 041395 A betreffen jeweils eine organisches elektrolumineszentes Bauteil. Weiterhin betrifft die Druckschrift US 2006/232194 A1 eine hybride OLED mit phosphoreszierenden und fluoreszierenden Emittern.

Hoch effiziente, phosphoreszente Emitter sind eine der Voraussetzungen für die Entwicklung hoch effizienter organischer lichtemittierender Dioden (OLEDs) sowie für Display- und Lightinganwendungen. Entscheidend hierfür ist einerseits die Quanteneffizienz des einzelnen Emittermoleküls und andererseits des Emitters insgesamt, die Stromeffizienz sowie die Leistungseffizienz des Systems (das heißt die Lichtleistung pro elektrischer Leistung).

Aufgabe der Erfindung ist es, eine strahlungsemittierende Vorrichtung mit verbesserter Effizienz bereitzustellen.

Diese Aufgabe wird durch die Vorrichtung gemäß den unabhängigen Ansprüchen gelöst. Weitere Ausgestaltungen sind Gegenstand von Unteransprüchen.

Die erfindungsgemäße strahlungsemittierende Vorrichtung umfasst ein Substrat, eine erste Elektrode und eine zweite Elektrode sowie eine zwischen der ersten und der zweiten Elektrode angeordnete Emitterschicht. Diese Emitterschicht weist ein Matrixmaterial auf, das 0,5 - 5 Gew.-% eines strahlungsemittierenden Emitters und 5 - 30 Gew.-% eines phosphoreszenten Exzitonenfängers enthält. Der Gewichtsanteil des Exzitonenfängers ist höher als der des strahlungsemittierenden Emitters. Weiterhin befindet sich das Emissionsmaximum des phosphoreszenten Exzitonenfängers bei einer kürzeren Wellenlänge als das Emissionsmaximum des strahlungsemittierenden Emitters. Die Stromeffizienz der Emitterschicht der strahlungsemittierenden Vorrichtung ist gegenüber der Stromeffizienz einer Emitterschicht, die keinen Exzitonenfänger enthält, um mindestens 10% erhöht.

Durch die erfindungsgemäße Emitterschicht, die neben Matrixmaterial und strahlungsemittierendem Emitter auch einen phosphoreszenten Exzitonenfänger umfasst, ist die Stromeffizienz der Emitterschicht gegenüber einer Emitterschicht ohne Exzitonenfänger e. Die Leitungseigenschaften des Dotierstoffs führen nämlich zu einem besseren Ladungsträgergleichgewicht sowie zu einer geringeren Spannung; neben einer erhöhten Quanteneffizienz führt dies zu einer Verbesserung der Leistungseffizienz.

Das bessere Ladungsträgergleichgewicht ist darauf zurückzuführen, dass die Matrix die Majoritätsladungsträger transportiert und der Exzitonenfänger die Minoritätsladungsträger (z.B. werden bei einer lochtranportierenden Matrix die Elektronen über das LUMO des Exzitonenfängers transportiert). Der Zusatz der Exzitonenfänger ermöglicht daher auch den Einsatz von Emittermaterialien, die nur in geringen Konzentrationen höchste Photolumineszenzeffizienten besitzen und dadurch zum Beispiel gute Langzeitstabilität aufweisen, also zum Einsatz für hoch effiziente OLEDs in Frage kommen. Diese Stoffe sind - wenn sie nicht in Mischung mit dem Exzitonenfänger vorliegen - weniger gut geeignet, da die wenigen im Matrixmaterial enthaltenen Emittermoleküle dann als Fallenzentren wirken, d.h. die Ladungsträgermobilität wird verringert (da die Ladungsträger auf den Fallenzentren "gefangen" sind). Dies hat zur Folge, dass die Betriebsspannung erhöht wird.

Durch die niedrig konzentrierten Emittermaterialien kann auch verhindert werden, dass insbesondere bei Emittern ohne sterische Hinderung bei hohen Konzentrationen eine Stapelung der Moleküle auftritt, welche eine Rotverschiebung des emittierten Spektrums zur Folge haben kann. Die hohen Konzentrationen des Exzitonenfängers bewirken dagegen - neben den vorstehenden Effekten, dass diese Exzitonenfänger nicht als Fallenzentren für die Ladungsträger wirken, sondern dass ein guter Transport der Ladungsträger stattfinden kann.

Die in den erfindungsgemäßen strahlungsemittierenden Vorrichtungen enthaltenen Emitterschichten weisen somit eine erhöhte Stromeffizienz (verglichen mit Emitterschichten ohne die erfindungsgemäßen Exzitonenfänger) auf, die um mindestens 10% erhöht ist (insbesondere bei Leuchtdichten von 10 bis 1100 cd/m²). Häufig liegt die Stromeffizienz sogar 20% und vielfach sogar 25% über der Stromeffizienz einer entsprechenden Emitterschicht ohne den erfindungsgemäßen Exzitonenfänger (insbesondere bei Leuchtdichten von 10 bis 1100 cd/m²). Dies gilt insbesondere für Stromeffizienzen bei hohen Lichtstärken, d.h. Lichtstärken, die typischerweise größer 1000 cd/m² sind.

Im Folgenden werden die einzelnen Komponenten der strahlungsemittierenden Vorrichtung der vorliegenden Erfindung näher erläutert:
Ein "Substrat" umfasst gemäß der vorliegenden Erfindung zum Beispiel ein Substrat, wie es im Stand der Technik herkömmlich für eine strahlungsemittierende Vorrichtung verwendet wird. Beispielsweise kann das Substrat Glas, Quarz, Kunststofffolien, Metall, Metallfolien, Siliziumwafer oder
ein anderes geeignetes Substratmaterial umfassen. Ist die strahlungsemittierende Vorrichtung zum Beispiel als so genannter "Bottom-Emitter" ausgeführt, ist das Substrat vorzugsweise transparent und beispielsweise als Glassubstrat ausgeführt.

In der erfindungsgemäßen strahlungsemittierenden Vorrichtung kann die erste Elektrode auf dem Substrat abgeschieden sein.

Die "erste Elektrode", wie sie hierin verwendet wird, kann zum einen eine Anode sein. Die Anode kann aus einem löcherinjizierenden Material bestehen. Als löcherinjizierendes Material kann jedes im Stand der Technik bekannte, löcherinjizierende Material verwendet werden. Ist die strahlungsemittierende Vorrichtung beispielsweise als "Bottom-Emitter" ausgebildet, so besteht die Anode üblicherweise aus einem transparenten Material. Beispielsweise kann sie aus transparenten leitenden Oxiden bestehen oder eine Schicht hieraus umfassen. Diese transparenten leitenden Oxide (transparent conductive oxides, "TCO") schließen Metalloxide, wie beispielsweise Zinkoxid, Zinnoxid, Cadmiumoxid, Titanoxid, Indiumoxid oder Indiumzinnoxid (ITO), Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide ein, sind jedoch nicht auf diese beschränkt. Die TCOs unterliegen dabei nicht zwingend einer stöchometrischen Zusammensetzung und können ferner auch p- oder n-dotiert sein.

Wenn die erste Elektrode eine Anode ist, ist die zweite Elektrode eine Kathode.
Die "Kathode" kann aus einem elektroneninjizierenden Material bestehen. Als Kathodenmaterialien können dabei im Stand der Technik übliche Kathodenmaterialien, insbesondere Aluminium, Barium, Indium, Silber, Gold, Magnesium, Calcium oder Lithium sowie Verbindungen, und Legierungen dieser Stoffe und Gemische der vorgenannten Elemente, Verbindungen und/oder Legierungen verwendet werden. Alternativ oder zusätzlich können auch eines oder mehrere der bei den Anoden-Materialien genannten TCOs enthalten sein bzw. kann die Kathode auch vollständig aus einem dieser Materialien bestehen. Die Kathode kann damit auch transparent ausgeführt sein.

In der strahlungsemittierenden Vorrichtung kann zum Beispiel eine Elektrode transparent und die andere reflektierend ausgeführt sein. Die strahlungsemittierende Vorrichtung kann somit entweder als "Bottom-Emitter" oder als "Top-Emitter" ausgeführt werden. Alternativ dazu können auch beide Elektroden transparent ausgeführt sein.

Die Emitterschicht der erfindungsgemäßen strahlungsemittierenden Vorrichtung bezeichnet eine funktionelle Schicht aus einem Matrixmaterial, das einen oder mehrere strahlungsemittierende Emitter und einen oder mehrere phosphoreszente Exzitonenfänger enthält beziehungsweise aus dem Matrixmaterial, dem mindestens einen Emitter und dem mindestens einen Exzitonenfänger besteht.

Der Emitter und der Exzitonenfänger können hierbei in ein Matrixmaterial eingebettet sein, das ausgewählt ist aus einer Gruppe, bestehend aus mCP (1,3-Bis(carbazol-9-yl)benzol), TCP (1,3,5-Tris(carbazol)-9-yl)benzol), TCTA (4,4',4"-Tris(carbazol-9-yl)triphenylamin), TPBi(1,3,5-tris(1-phenyl-1-H-benzimidazol-2-yl)benzol), CBP (4,4'-Bis(carbazol-9-yl)biphenyl), CDBP (4,4'-Bis(9-carbazolyl)-2,2'-dimethylbiphenyl), (DMFL-CBP 4,4'-Bis(carbazol-9-yl)-9,9-dimethylfluoren), FL-4CBP (4,4'-Bis(carbazol-9-yl)-9,9-bis(9-phenyl-9H-carbazol)fluoren), DPFL-CBP (4,4'-Bis(carbazol-9-yl)-9,9-ditolylfluoren), FL-2CBP (9,9-Bis(9-phenyl-9H-carbazol)fluoren), Spiro-CBP (2,2',7,7'-Tetrakis(carbazol-9-yl)-9,9'-spiro-bifluoren), ADN (9,10-Di(naphth-2-yl)anthracen, TBADN (3-Tert-butyl-9,10-di(naphth-2-yl)anthracen, DPVBi (4,4'-Bis(2,2-diphenyl-ethen-1-yl)-4,4'-dimethylphenyl), p-DMDPVBi (4,4'-Bis(2,2-diphenyl-ethen-1-yl)-4,4'-dimethylphenyl), TDAF (Tert(9,9-diarylfluoren)), BSBF (2-(9,9'-Spirobifluoren-2-yl)-9,9'-spirobifluoren), TSBF (2,7-Bis(9,9'-spirobifluoren-2-yl)-9,9'-spirobifluoren), BDAF Bis(9,9-diarylfluoren), p-TDPVBi (4,4'-Bis(2,2-diphenyl-ethen-1-yl)-4,4'-di-(tert-butyl)phenyl), TPB3 (1,3,5-Tri-(pyren-1-yl)benzol) sowie aus Gemischen der vorgenannten Stoffe. Als Matrixmaterial bevorzugt sind die Materialen TCTA, TPBi, CBP, CDBP und CPF. Als Matrixmaterialien die in gemischten System vorliegen, werden bevorzugt Mischungen aus einem oder mehreren der Materialien TCTA, mCP, CBP, CDBP oder CPF untereinander oder Mischungen mit TPBi verwendet.

Das Emittermaterial kann beispielsweise ein Emissionsmaximum im blauen, grünen oder roten Spektralbereich aufweisen. Weist ein derartiges Emittermaterial mehrere Emissionsmaxima auf, so gilt als Emissionsmaximum im Sinne dieser Erfindung das Emissionsmaximum mit der größten Intensität.

Existieren bei unterschiedlichen Stromstärken zwei oder mehr intensitätsstärkste Emissionsmaxima bei unterschiedlichen Wellenlängen, so gilt von diesen Emissionsmaxima im Sinne dieser Erfindung das Maximum bei der kleineren Wellenlänge als Emissionsmaximum (insbesondere für die Bestimmung der Differenz der Wellenlängen des Emissionsmaximums des strahlungsemittierenden Emitters und des Emissionsmaximums des Exzitonenfängers).

Ein blau phosphoreszierendes Emittermaterial kann ausgewählt sein aus der Gruppe, bestehend aus FIrPic (Bis(3,5-difluoro-2-(2-pyridyl)phenyl-(2-carboxypyridyl)-iridium III), Flr6 (Bis(48,68-difluorophenylpyridinato)-tetrakis(1-pyrazolyl)borat-iridium III) sowie aus Gemischen der vorgenannten Stoffe. Die genannten Emittermaterialien haben ihr Emissionsmaximum im blauen Spektralbereich.
Grün phosphoreszierendes Emittermaterial kann ausgewählt sein aus der Gruppe, bestehend aus Ir(ppy)₃ (Tris(2-phenylpyridin)iridium(III)), Ir(ppy)₂(acac) (Bis(2-phenylpyridin)(acetylacetonat)iridium(II)), Iridium (III)-tris(2-(4-tolyl)pyridinato-N,C2), Tris(2-phenylpyridin)iridium (III), Tris(8-hydroxychinolato)aluminium (III), Tris(2-methyl,8-hydroxychinolato)aluminium (III), Tris(8-hydroxychinolato)gallium (III), Tris(3-methyl-1-phenyl-4-trimethyl-acetyl-5-pyrazolin)terbium (III) sowie aus Gemischen der vorgenannten Stoffe. Die genannten Emittermaterialien haben ihr Emissionsmaximum im grünen Spektralbereich.

Als rot phosphoreszierendes Emittermaterial kann ein Emittermaterial eingesetzt werden, das ausgewählt ist aus der Gruppe bestehend aus Ir(mdq)₂(acac) (Bis(2-methyl-dibenzo[f,h]-chinoxalin)(acetylacetonat)iridium(III)), Eu(dbm)3(phen) (Tris(dibenzoylmethan)phenanthrolin-europium(III)), Ir(btp)₂(acac) (Bis(2-benzo[b]thiophen-2-yl-pyridin) (acetylacetonat)iridium(III)), Ir(piq)₂(acac) (Bis(1-phenylisochinolin) (acetylacetonat)iridium(III)), Ir(fliq)₂(acac)-1 (Bis[1-(-9,9-dimethyl-9H-fluoren-2-yl)-isochinolin](acetylacetonat)iridium(III)), Ir(flq)₂(acac)-2 (Bis[3-(9,9-dimethyl-9H-fluoren-2-yl)-isochinolin](acetylacetonat)iridium(III)), Ru(dtb-bpy)₃*2(PF₆)(Tris[4,4'-di-tert-butyl-(2,2')-bipyridin]ruthenium(III)komplex), Ir(2-phq)₃ (Tris(2-phenylchinolin)iridium(III)), Ir(2-phq)₂(acac)(Bis(2-phenylchinolin)(acetylacetonat)iridium(III)), Ir(piq)₃ (Tris-(1-phenylisochinolin)iridium(III)), Iridium (III)-bis(2-(2'-benzothienyl)pyridinato-N,C3')(acetylacetonat), Tris(dibenzoylacetonato)-mono(phenanthrolin)-europium (III), Tris(dibenzoylmethan)-mono(phenanthrolin)-europium (III), Tris(dibenzoylmethan)-mono(5-aminophenanthrolin)-europium (III), Tris(dinaphthoylmethan)-mono(phenanthrolin)-europium (III), Tris(4-brombenzoylmethan)-mono(phenanthrolin)-europium (III), Tris(dibiphenoylmethan)-mono(phenanthrolin)-europium (III), Tris(dibenzoylmethan)-mono(4,7-dimethylphenanthrolin)-europium (III), Tris(dibenzoylmethan)-mono(4,7-dimethylphenanthrolin-disulfonsäure)-europium (III)-dinatriumsalz, Tris[di(4-(2-(2-thoxyethoxy)ethoxy)benzoyl-methan)]-mono(phenanthrolin)-europium (III), Tris[di(4-(2-(2-thoxyethoxy)ethoxy)benzoylmethan)]-mono(5-aminophenanthrolin)-europium (III) sowie aus Gemischen der vorgenannten Stoffe. Die genannten Emittermaterialien haben ihr Emissionsmaximum im roten Spektralbereich.

Weiterhin können als Emittermaterialien auch fluoreszierende Emitter eingesetzt werden.

Als blau fluoreszierender Emitter kann dabei eine Verbindung eingesetzt werden, die ausgewählt ist aus der Gruppe, bestehend aus BCzVBi (4,4'-Bis(9-ethyl-3-carbazovinylen)-1,1'-biphenyl), Perylen, TBPe (2,5,8,11-Tetra-tert-butylperylen), BCzVB (9H-Carbazol-3,3'-(1,4-phenylen-di-2,1-ethendiyl)bis[9-ethyl-(9C)]), DPAVBi 4,4-Bis[4-(di-p-tolylamino)styryl]biphenyl, DPAVB (4-(Di-p-tolylamino)-4'-[(di-p-tolylamino)styryl]stilben), BDAVBi (4,4'-Bis[4-(diphenylamino)styryl]biphenyl), BNP3FL (N,N'-Bis(naphthalen-2-yl)-N,N'-bis(phenyl)-tris-(9,9-dimethylfluorenylen), 9,10-Bis[(9-ethyl-3-carbazoyl)-vinylenyl]-anthracen, 4,4'-Bis(diphenylvinylenyl)-biphenyl, 1,4-Bis(9-ethyl-3-carbazovinylen)-2-methoxy-5-(2-thylhexyloxy)benzol, 4,4'-Bis(diphenylvinylenyl)-anthracen, 1,4-Bis(9-ethyl-3-carbazovinylen)-9,9-dihexyl-fluoren sowie aus Gemischen der vorgenannten Stoffe. Die genannten Emittermaterialien haben ihr Emissionsmaximum im blauen Spektralbereich. Weiterhin können auch rot oder grün fluoreszierende Emittermaterialien eingesetzt werden.

Die Emitterschicht der erfindungsgemäßen strahlungsemittierenden Vorrichtung weist neben dem strahlungsemittierenden Emitter auch noch einen phosphoreszenten Exzitonenfänger auf.

Bei dem phosphoreszenten Exzitonenfänger handelt es sich um eine Verbindung, auf die ein effizienter Energieübertrag vom Matrixmaterial möglich ist. Im Betrieb werden daher zunächst Exzitonen vom Matrixmaterial auf den Exzitonenfänger übertragen beziehungsweise direkt auf diesem gebildet. Dem Exzitonenfänger kommt dann die Aufgabe zu, einen effizienten und schnellen Energieübertrag auf das Emittermaterial zu gewährleisten. Es werden Exzitonen auf dieses Emittermaterial übertragen.

Der phosphoreszente Exzitonenfänger ermöglicht ferner einen guten Transport der Minoritätsladungsträger in einer Matrix, in der die Majoritätsladungsträger mit entgegengesetzter Ladung transportiert werden (bei einem lochtransportierenden Wirtsmaterial ermöglichen die Exzitonenfänger also einen guten Elektronentransport).

Obwohl der Exzitonenfänger eine phosphoreszente Verbindung ist, kommt es also nicht darauf an, dass der Exzitonenfänger Strahlung emittiert; vielmehr ist es wesentlich, dass der Exzitonenfänger einen guten Transport sowohl der Ladungsträger als auch der Exzitonen gewährleistet. Die als Exzitonenfänger verwendeten Materialien unterscheiden sich stets von den als Emitter eingesetzten Materialien.

Als Exzitonenfänger sind weitesgehend dieselben Verbindungen wie für die vorstehend genannten phosphoreszenten Emittermaterialien geeignet, sofern das Emissionsmaximum des phosphoreszenten Exzitonenfängers bei einer kürzeren Wellenlänge als das Emissionsmaximum des strahlungsemittierenden Emitters liegt.

In einer Ausführungsform beträgt der Anteil des Exzitonenfängers 10 - 20 Gew.-% (im Rahmen der vorliegenden Erfindung beziehen sich alle Angaben in Gew.-% stets auf das in der Emitterschicht enthaltene Matrixmaterial). Ab einem Gewichtsanteil von mindestens 10 Gew.-% ist im Matrixmaterial soviel Exzitonenfänger enthalten, dass ein sehr effizienter Transport der Ladungsträger ermöglicht wird und daher ein deutlicher Anstieg der Stromeffizienz zu verzeichnen ist. Ab einem Anteil von 20 Gew.-% kann es unter Umständen dazu kommen, dass durch Wechselwirkungen von zwei Exzitonen Effizienzverluste erfolgen.

In einer weiteren Ausführungsform ist der Anteil des strahlungsemittierenden Emitters 1 - 4 Gew.-%. Ab einem Gewichtsanteil von 5 Gew.-% ist mit einem Konzentrationsquenching und daher einer deutlich sinkenden Effizienz zu rechnen.

In weiteren Ausführungsformen ist der Gewichtsanteil des Exzitonenfängers zumindest viermal, häufig sogar achtmal, so hoch wie der des strahlungsemittierenden Emittermaterials. In einer weiteren Ausführungsform liegt entweder das HOMO des Exzitonenfängers so, dass - sofern das Matrixmaterial ein Material ist, das Elektronen besser transportiert - eine Injektion der Löcher (d.h. ein Übertrag der Löcher von der anodenseitig auf die Emitterschicht folgenden Schicht auf die Exzitonenfänger) erleichtert wird oder es liegt das LUMO des Exzitonenfängers so, dass - sofern das Matrixmaterial ein Material ist, das Löcher besser transportiert - eine Injektion von Elektronen (von der kathodenseitig auf die Emitterschicht folgenden Schicht auf die Exzitonenfänger) erleichtert wird. Insbesondere liegt daher das LUMO des Exzitonenfängers bei einem besser lochtransportierenden Matrixmaterial um bis zu 0,3 Elektronenvolt über oder unter dem LUMO der kathodenseitig auf die Emitterschicht folgenden Schicht. Bevorzugt liegt das LUMO um 0 - 0,3 Elektronenvolt unter diesem Energieniveau. Bei besser elektronenleitenden Matrixmaterialien liegt das HOMO des Exzitonenfängers bevorzugt um bis zu 0,3 Elektronenvolt unter oder über dem HOMO der anodenseitig auf die Emitterschicht folgenden Schicht. Besonders bevorzugt ist ein HOMO, das 0 - 0,3 Elektronenvolt unter dem HOMO dieser Schicht liegt.
HOMO steht hierbei für "Highest Occupied Molecular Orbital" und LUMO für "Lowest Unoccupied Molecular Orbital".

Kathodenseitig kann beispielsweise eine Elektronentransportschicht auf die Emitterschicht folgen; anodenseitig kann beispielsweise eine Lochtransport-Schicht auf die Emitterschicht folgen.

In einer weiteren Ausführungsform beträgt die Differenz der Wellenlängen des Emissionsmaximums des strahlungsemittierenden Emitters und des Emissionsmaximums des Exzitonenfängers mindestens 15 nm, üblicherweise sogar mindestens 30 nm. Üblicherweise wird für Emittermaterialien, die im gelben, orangen oder roten Spektralbereich emittieren, ein Exzitonenfänger eingesetzt, der ein Emissionsmaximum im blauen oder grünen Spektralbereich aufweist; für grün emittierende Emittermaterialien wird ein Exzitonenfänger, der ein Emissionsmaximum im blauen Spektralbereich aufweist eingesetzt und für blau emittierende Emittermaterialen ein Exzitonenfänger, der im violetten oder ultravioletten Spektralbereich das Emissionsmaximum aufweist. Insbesondere bei blau emittierenden Emittermaterialien beträgt die Differenz der Wellenlängen der Emissionsmaxima maximal 100 nm. Als roter, oranger, gelber, grüner, blauer und violetter Spektralbereich gelten erfindungsgemäß generell folgende Bereiche: roter Spektralbereich etwa 640 bis 780 nm; oranger Spektralbereich etwa 600 bis 640 nm, gelber Spektralbereich etwa 570 bis 600 nm, grüner Spektralbereich etwa 500 bis 570 nm, blauer Spektralbereich etwa 430 bis 500 nm, violetter Spektralbereich etwa 380 bis 430 nm.

In einer weiteren Ausführungsform wird die von der Emitterschicht der erfindungsgemäßen strahlungsemittierenden Vorrichtung emittierte Strahlung im Wesentlichen durch den strahlungsemittierenden Emitter erzeugt. Aufgrund der sehr guten Ladungsträger und Exzitonenleitfähigkeit des Exzitonenfängers werden die in Matrixmaterial oder auf dem Exzitonenfänger gebildeten Exzitonen im Wesentlichen auf das Emittermaterial übertragen, so dass das von der Emitterschicht emittierte Licht im Wesentlichen denselben Farbeindruck hervorruft wie das Licht, das von einer Emitterschicht ohne Exzitonenfänger emittiert wird, hervorruft. Unter einem im Wesentlichen gleichen Farbeindruck wird hierbei insbesondere verstanden, dass die CIE-Koordinaten des emittierten Lichts einer Emitterschicht ohne Exzitonenfänger (x_{oE}, y_{oE}) sich nicht wesentlich von denen einer Emitterschicht mit Exzitonenfänger (x_{mE}, y_{mE}) unterscheiden. Im Regelfall gilt für die Differenz Δx = x_{oE} - x_{mE} bzw. die Differenz Δy = y_{oE} - y_{mE}, dass Δx < 0,05 und/oder Δy < 0,05. Häufig gilt sogar Δx < 0,03 und/oder Δy < 0,03 und vielfach auch Δx < 0,01 und/oder Δy < 0,01. Für die Summe der Absolutbeträge dieser Differenzen ∑_{Δ} = |Δx| + |Δy| gilt im Regelfall ∑_{Δ} < 0,08, häufig gilt ∑_{Δ} < 0,05 und vielfach auch ∑_{Δ} < 0,01.

Vielfach ist bereits anhand des normalisierten Emissionsspektrums erkennbar, dass die Exzitonen vom Exzitonenfänger auf den strahlungsemittierenden Emitter übertragen werden. Üblicherweise beträgt nämlich die Intensität der normalisierten Emission des Emissionsmaximums des Exzitonenfängers in einem für die Emitterschicht mit Exzitonenfänger und strahlungsemittierendem Emitter gemessenen Spektrum maximal 10% der Intensität des Emissionsmaximums des strahlungsemittierenden Emitters. Die Intensität des Emissionsmaximums des Exzitonenfängers liegt bei maximal 5%, häufig sogar bei maximal 1%, der Intensität des Emissionsmaximums des strahlungsemittierenden Emitters. Die gemessenen Intensitätsverhältnisse sind hierbei üblicherweise unabhängig von der Stromdichte, insbesondere bei Stromdichten zwischen 0,5 und 10 mA/cm².

Üblicherweise ist es zudem so, dass auch die Intensität des Emissionsmaximums des Exzitonenfängers in einer Emitterschicht mit Exzitonenfänger und strahlungsemittierendem Emitter deutlich gegenüber der Intensität des Emissionsmaximums einer Emitterschicht, die nur den Exzitonenfänger (in gleicher Konzentration wie im vorstehend genannten "gemischten" System) und kein strahlungsemittierendes Emittermaterial enthält, reduziert ist. Die (bei gleicher Stromdichte von z.B. 5 mA/cm² gemessene) Intensität der normalisierten Emission des Emissionsmaximums des Exzitonenfängers in der Emitterschicht mit Emitter und Exzitonenfänger beträgt maximal 5% der normalisierten Emission des Emissionsmaximums des Exzitonenfängers in einer Schicht, die nur aus dem Matrixmaterial und dem Exzitonenfänger besteht. Üblicherweise beträgt die (bei gleicher Stromdichte von z.B. 5 mA/cm² gemessene) Intensität der normalisierten Emission des Emissionsmaximums des Exzitonenfängers in der Emitterschicht mit Emitter und Exzitonenfänger dann maximal 10%, und häufig sogar maximal 1% der normalisierten Emission des Emissionsmaximums des Exzitonenfängers in einer Schicht, die nur aus dem Matrixmaterial und dem Exzitonenfänger besteht. Wie vorstehend beschrieben wurde, ist dies im Wesentlichen auf die gute Exzitonenleitfähigkeit des Exzitonenfängers zurückzuführen.

Die gute Exzitonenleitfähigkeit kann auch anhand der zeitaufgelösten wellenlängenabhängigen Emissionsspektren bestimmt werden. Vergleicht man hier eine Emitterschicht, die einen Exzitonenfänger und ein strahlungsemittierendes Emittermaterial enthält, mit einer identischen Schicht, die in denselben Konzentrationen jeweils nur den Exzitonenfänger beziehungsweise nur das strahlungsemittierende Emittermaterial enthält, so stellt man fest, dass sich die Halbwertszeit der Intensität der Emission des Emissionsmaximums des Exzitonenfängers im "gemischten System" deutlich reduziert hat während die Halbwertszeit der Intensität der Emission des Emissionsmaximums des strahlungsemittierenden Emittermaterials im Wesentlichen gleich bleibt. Häufig ist zu beobachten, dass sich die Halbwertszeit um mindestens die Hälfte reduziert. Oft beträgt die Halbwertszeit sogar nur 40% und vielfach sogar nur 33% der Halbwertszeit, die für ein Matrixmaterial, in dem ausschließlich der Exzitonenfänger enthalten ist, gemessen wurde. Dieser Effekt bedeutet unter anderem auch, dass die Lebensdauer der Exzitonen auf dem strahlungsemittierenden Emitter im Regelfall länger ist als die Lebensdauer der Exzitonen auf dem Exzitonenfänger. Vergleicht man diese Lebensdauer mit den Lebensdauern von Matrixmaterialien, in die jeweils ausschließlich der Exzitonenfänger oder das strahlungsemittierende Emittermaterial in gleicher Konzentration enthalten ist, so stellt man fest, dass in den nicht "gemischten Systemen" genau die umgedrehte Situation vorliegen kann, also die Lebensdauer der Exzitonen auf dem Exzitonenfänger länger sein kann, als die der Exzitonen im parallelen System auf dem strahlungsemittierenden Emitter.

Die vorstehend beschriebenen Effekte führen im Regelfall auch dazu, dass die externe Quanteneffizienz der Emitterschicht deutlich erhöht werden kann. Vergleicht man die externe Quanteneffizienz einer Emitterschicht mit Exzitonenfänger und strahlungsemittierendem Emitter mit der Quanteneffizienz einer Emitterschicht, die nur den strahlungsemittierenden Emitter (in der gleichen Konzentration) und keinen Exzitonenfänger enthält, so stellt man fest, dass die Quanteneffizienz zumeist um mindestens 20% erhöht ist. Häufig kann sogar eine Erhöhung um 30% festgestellt werden. Mit der erfindungsgemäßen Emitterschicht können daher externe Quanteneffizienzen ηₑₓₜ größer 12%, häufig sogar größer 14% erreicht werden. Es können sogar Quanteneffizienzen zwischen über 18%, z.B. von 20% erreicht werden.

In einer weiteren Ausgestaltung weist der in der Emitterschicht enthaltene strahlungsemittierende Emitter eine hohe Photolumineszenzquantenausbeute auf, insbesondere auch bei niedrigen Emitterkonzentrationen. Im Regelfall wird diese Photolumineszenzquantenausbeute η_{PL} niedriger sein als die des Exzitonenfängers. Weiterhin besitzen auch die Exzitonen auf dem strahlungsemittierenden Emittermaterial eine relativ kurze Lebensdauer. Im Regelfall beträgt diese maximal 20 µs.

In einer weiteren Ausgestaltung weist das strahlungsemittierende Emittermaterial ein LUMO auf, das über dem LUMO des Exzitonenfängers liegt. Dies führt dazu, dass die Exzitonen im Wesentlichen vom Exzitonenfänger eingefangen beziehungsweise auf diesem gebildet werden und der Exzitonenfänger beziehungsweise das strahlungsemittierende Emittermaterial im Wesentlichen die Aufgaben erfüllen können, die ihnen zugedacht sind. Es erfolgt dann im Wesentlichen eine Übertragung der im Matrixmaterial gebildeten Exzitonen auf den Exzitonenfänger und nicht auf das strahlungsemittierende Emittermaterial, das wiederum besonders effizient dazu dienen kann, Strahlung zu emittieren. Die Erfindung ist allerdings nicht hierauf beschränkt, vielmehr kann das LUMO des strahlungsemittierenden Emitters auch unter dem des Exzitonenfängers liegen. Weiterhin können des LUMO des Exzitonenfängers und gegebenenfalls auch des strahlungsemittierenden Emitters niedriger als das des Matrixmaterials liegen. Dies führt dazu, dass die Exzitonen verstärkt auf dem Exzitonenfänger gebildet werden und daher der Schritt der Übertragung der auf der Matrix gebildeten Exzitonen auf den Exzitonenfänger entfällt.

In einer weiteren Ausgestaltung hat die Emitterschicht der strahlungsemittierenden Vorrichtung eine Schichtdicke von 10 - 40 nm. Emitterschichten mit geringeren Schichtdicken sind schwerer zu prozessieren; außerdem kann ab einer Schichtdicke von 10 nm die Anzahl der Emitterzentren optimiert werden und damit besser an die Lebensdauer der Exzitonen angepasst werden. Im Einzelfall kann aber auch eine Schichtdicke zwischen 5 und 10 nm technisch sinnvoll sein. Für die Herstellung einer weißes Licht emittierenden strahlungsemittierenden Vorrichtung, die mehrere Emitterschichten enthält, beträgt die Schichtdicke der einzelnen Emitterschichten bevorzugt jeweils 10 - 15 nm.

Üblicherweise ist der Emitter und auch der Exzitonenfänger statistisch über das Matrixmaterial verteilt. Allerdings können auch Konzentrationsgradienten in der Emitterschicht vorliegen, so dass sich beispielsweise Bereiche, in denen der Exzitonenfänger höher konzentriert ist mit Bereichen, in denen das Emittermaterial im Verhältnis höher konzentriert ist abwechseln; es können in der Emitterschicht sogar auch nur Bereiche vorliegen, in denen ausschließlich Exzitonenfänger enthalten ist und Bereiche in denen ausschließlich der phosphoreszente Emitter enthalten ist.Hiermit können gezielt Zonen eingestellt werden, in denen entweder Exzitonen gebildet werden beziehungsweise Zonen, in denen die Emission erfolgt.

Die strahlungsemittierende Vorrichtung weist eine weitere Emitterschicht, häufig insgesamt zumindest zwei oder drei Emitterschichten, auf. Hierbei enthält eine Emitterschicht - wie die erste Emitterschicht - neben dem strahlungsemittierenden Emitter auch einen Exzitonenfänger. Mehrere der weiteren Emitterschichten - wie die erste Emitterschicht - können neben dem strahlungsemittierenden Emitter auch einen Exzitonenfänger enthalten. Für diese weiteren Emitterschichten gelten die vorstehend für die erste Emitterschicht gemachten Ausführungen entsprechend.

Es liegen zwischen jeweils zwei der Emitterschichten Blockierschichten vor. Enthält die strahlungsemittierende Vorrichtung mehr als zwei Emitterschichten, so kann zwischen allen Emitterschichten eine Blockierschicht vorliegen aber auch nur zwischen einem Teil der Emitterschichten. Eine solche Blockierschicht dient zum Blockieren von Exzitonen. Eine solche Blockierschicht kann dabei so gestaltet sein, dass ihre Dicke größer ist als die mittlere freie Weglänge der in der jeweils benachbarten Schicht gebildeten Exzitonen, so dass diese im Wesentlichen nicht in die zweite Schicht gelangen können. Ferner kann die Blockierschicht alternativ oder gleichzeitig auch zumindest in Teilen der Schicht zum Blockieren von Ladungsträgern (Elektronen oder Löchern) dienen. Durch Schichten oder Teilbereiche von Schichten, die Ladungsträger blockieren kann eine gezielte Einstellung der Ladungsträgerdichte erfolgen. Eine Blockierschicht zum Blockieren von Exzitonen und/oder Ladungsträgern kann ein oder mehrere Matrixmaterialien umfassen oder hieraus bestehen, wobei geeignete Matrixmaterialien aus den vorstehend offenbarten Matrixmaterialien ausgewählt werden können. Alternativ können Schichten die Elektronen blockieren eines oder mehrere der nachfolgenden Materialien für Lochtransport-Schichten umfassen oder diese(s) und ein oder mehrere Matrixmaterialien umfassen. Ferner können Schichten die Löcher blockieren eines oder mehrere der nachfolgenden Materialien für Elektronentransport-Schichten umfassen oder diese(s) und ein oder mehrere Matrixmaterialien umfassen.

In einer weiteren Ausgestaltung emittiert die erfindungsgemäße strahlungsemittierende Vorrichtung Weißlicht. Dieses Weißlicht kann gebildet werden durch die Überlagerung der Strahlung, die durch die erste Emitterschicht und die zumindest eine weitere Emitterschicht emittiert wird. Üblicherweise werden hierfür zumindest drei Emitterschichten (zum Beispiel Emitterschichten die jeweils im roten, grünen und blauen Spektralbereich emittieren) verwendet. Denkbar ist allerdings auch ein System, das nur zwei Emitterschichten enthält (beispielsweise eine blau und eine orange emittierende Schicht).

Zusammenfassend kann festgestellt werden, dass erfindungsgemäß erkannt wurde, dass durch die Kombination eines phosphoreszenten Exzitonenfängers in hoher Konzentration und eines Emittermaterials in niedriger Konzentration unabhängig voneinander zwei Effekte realisiert werden können. Zum einen werden durch dieses gemischte System im Betrieb zunächst Exzitonen vom Matrixmaterial auf den Exzitonenfänger übertragen beziehungsweise auf dem Exzitonenfänger gebildet. Durch einen effizienten und schnellen Energieübertrag gelangen die Exzitonen dann auf das Emittermaterial, auf dem sie effizient, strahlend zerfallen können. Außerdem weist der Exzitonenfänger hervorragende Leitungseigenschaften für die Minoritätsladungsträger auf. Beide Effekte führen insgesamt zu einem besseren Ladungsträgergleichgewicht und zu einer geringeren Spannung, was neben der erhöhten Quanteneffizienz zu einer weiteren Verbesserung der Leistungseffizienz beiträgt. Durch das erfindungsgemäße System ist es auch möglich, dass nicht ein spezifisches optimiertes Matrix/Emittermaterial-System zum Einsatz kommen muss, sondern ein weiterer Parameter existiert, der die Bandbreite der verwendbaren Matrixmaterialien vergrößert.

Die strahlungsemittierende Vorrichtung kann auch weitere funktionelle Schichten aufweisen. Solche Schichten können beispielsweise Elektronentransportschichten, Elektroneninjektionsschichten, Lochtransportschichten und/oder Lochinjektionsschichten sein. Solche Schichten können dazu dienen, die Effizienz der strahlungsemittierenden Vorrichtung weiter zu steigern und an einer oder mehreren geeigneten Stellen der strahlungsemittierenden Vorrichtung ausgebildet werden. Sie können geeignete Elektronentransportmaterialien und/oder Lochtransportmaterialien und/oder zur Verbesserung der Lochinjektion geeignete Materialien umfassen.

Als Elektronentransportmaterialien seien beispielsweise Liq (8-Hydroxychinolinolato-lithium), TPBi (2,2',2"-(1,3,5-Benzintriyl)-tris(1-phenyl-1-H-benzimidazol)), PBD (2-(4-Biphenylyl)-5-(4-tert-butylphenyl)), BCP (2,9-Dimethyl-4,7-diphenyl-1,10-phenanthrolin), BPhen (4,7-Diphenyl-1,10-phenanthrolin), BAlq (Bis-(2-methyl-8-chinolinolat)-4-(phenylphenolato)aluminium) und TAZ (3-(4-Biphenylyl)-4-phenyl-5-tert-butylphenyl-1,2,4-triazol) sowie Gemische der vorgenannten Stoffe genannt. Für die Elektronentransportschicht (die zugleich als Exzitonen-Blockierschicht dienen kann) werden bevorzugt Stoffe ausgewählt aus der Gruppe, bestehend aus TPBi, BCP, Bphen, CzSi und TAZ sowie aus Gemischen dieser Stoffe.

Als Lochtransportmaterialien seien zum Beispiel NPB (N,N'-Bis(naphthalen-1-yl)-N,N'-bis(phenyl)-benzidin, β-NPB (N,N'-Bis(naphthalen-2-yl)-N,N'-bis(phenyl)-benzidin), TPD (N,N'-Bis(3-methylphenyl)-N,N'-bis(phenyl)-benzidin), Spiro-TPD (N,N'-Bis(3-methylphenyl)-N,N'-bis(phenyl)-benzidin), Spiro-NPB (N,N'-Bis(naphthalen-1-yl)-N,N'-bis(phenyl)-spiro), DMFL-TPD (N,N'-Bis(3-methylphenyl)-N,N'-bis(phenyl)-9,9-dimethylfluoren, DMFL-NPB (N,N'-Bis(naphthalen-1-yl)-N,N'-bis(phenyl)-9,9-dimethylfluoren), DPFL-TPD (N,N'-Bis(3-methylphenyl)-N,N'-bis(phenyl)-9,9-diphenylfluoren), DPFL-NPB (N,N'-Bis(naphthalen-1-yl)-N,N'-bis(phenyl)-9,9-diphenylfluoren), Sp-TAD (2,2',7,7'-Tetrakis(n,n-diphenylamino)-9,9'-spirobifluoren) und TAPC (Di-[4-(N,N-ditolyl-amino)-phenyl]cyclohexan) oder Gemische der vorgenannten Stoffe genannt. Für die Lochtransport-Schicht (die ebenfalls gleichzeitig als Exzitonen-Blockierschicht dienen kann) werden bevorzugt Stoffe ausgewählt aus der Gruppe, bestehend aus NPB, TCTA, TPD, Sp-TAD und TAPC sowie aus Gemischen dieser Stoffe.

Als zur Verbesserung der Lochinjektion geeignete Materialien, seien beispielsweise CuPC (Phthalocyanin, Kupferkomplex), TiOPC (Titanoxidphthalocyanin), m-MTDATA (4,4',4"-Tris(N-3-methylphenyl-N-phenylamino)triphenylamin), 2T-NATA (4,4',4"-Tris(N-(2-naphthyl)-N-phenyl-amino)triphenylamin), IT-NATA (4,4',4"-Tris(N-(1-naphthyl)-N-phenylamino)triphenylamin), NATA (4,4',4"-Tris(N,N-diphenylamino)triphenylamin) sowie Gemische der vorgenannten Stoffe genannt, wobei die angegebenen Materialien optional dotiert sein können.

Im Folgenden wird die vorliegende Erfindung anhand von Beispielen und Figuren beschrieben.
Figur 1 zeigt eine schematische Übersicht über eine strahlungsemittierende Vorrichtung gemäß der vorliegenden Erfindung.
Figur 2 zeigt eine schematische Darstellung der Energieniveaus einer Ausführungsform einer OLED-Struktur.
Figur 3 zeigt die verbesserte Stromeffizienz der Emitterschicht in Abhängigkeit von der Leuchtdichte.
Figur 4 zeigt das Elektrolumineszenz-Spektrum für Emitterschichten mit und ohne Exzitonenfänger bzw. mit und ohne Emitter bei einer Stromdichte von 5 mA/cm².
Die Figuren 5a bis 5c zeigen das Elektrolumineszenz-Spektrum für Schichten mit und ohne Exzitonenfänger bzw. mit und ohne Emitter bei verschiedenen Stromdichten.

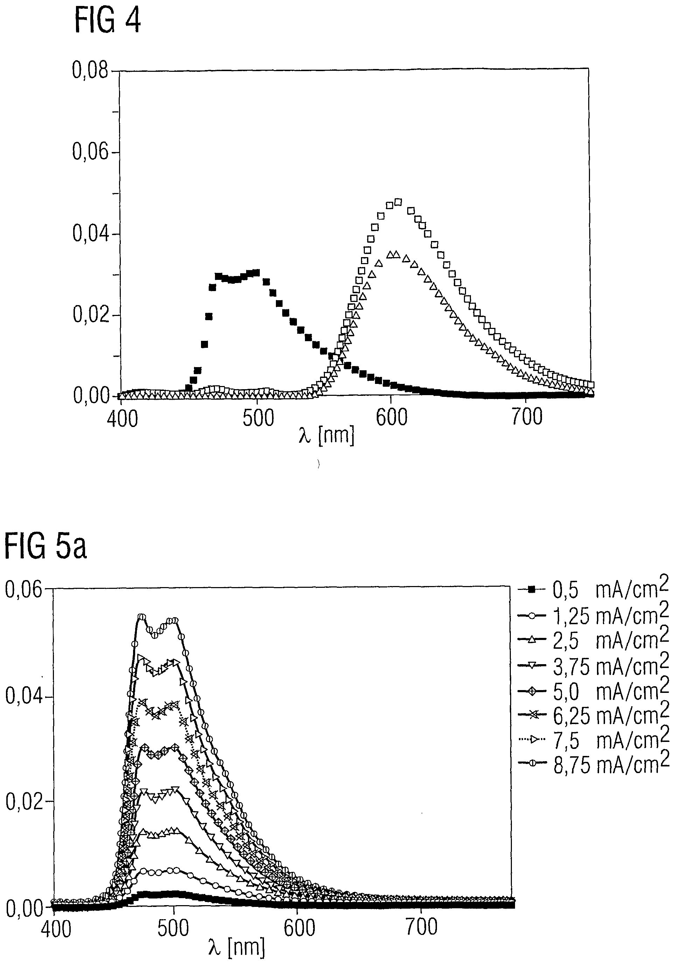

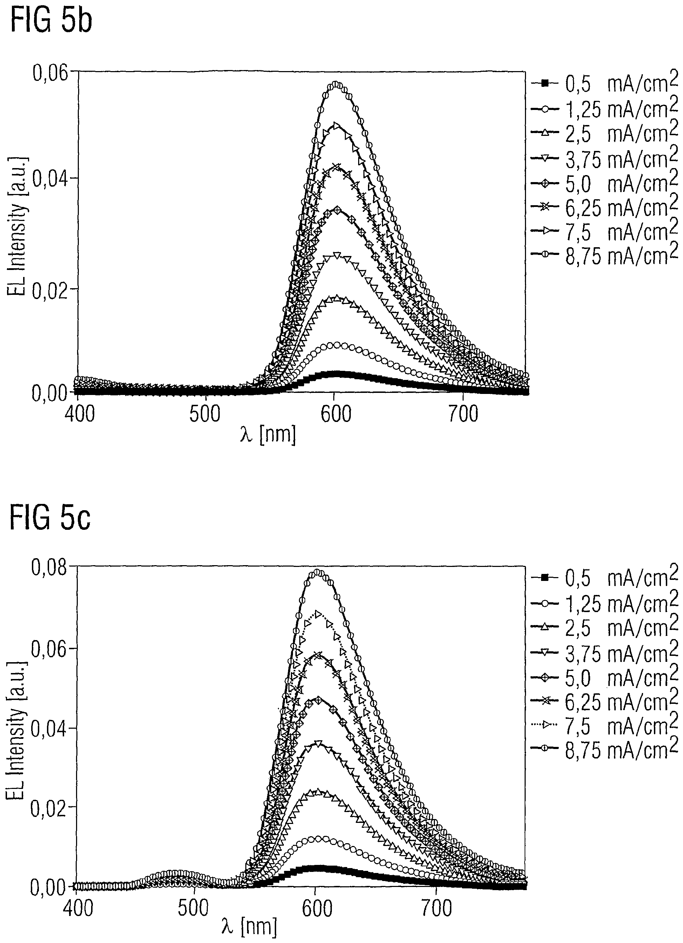

Figur 5 zeigt die Verbesserung der Strom-Spannungs-Charakteristik.

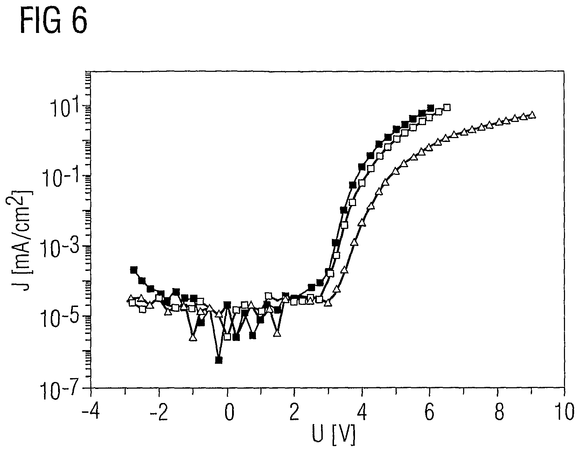

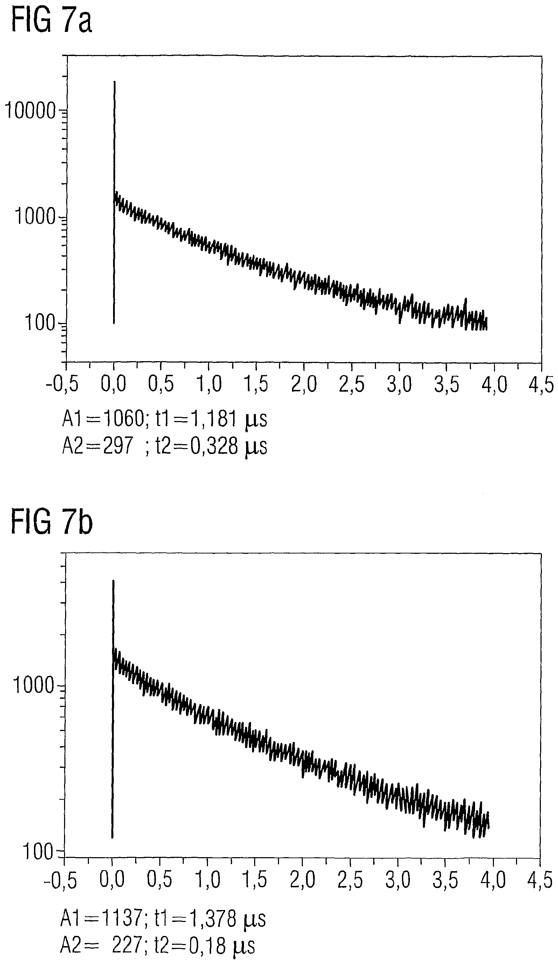

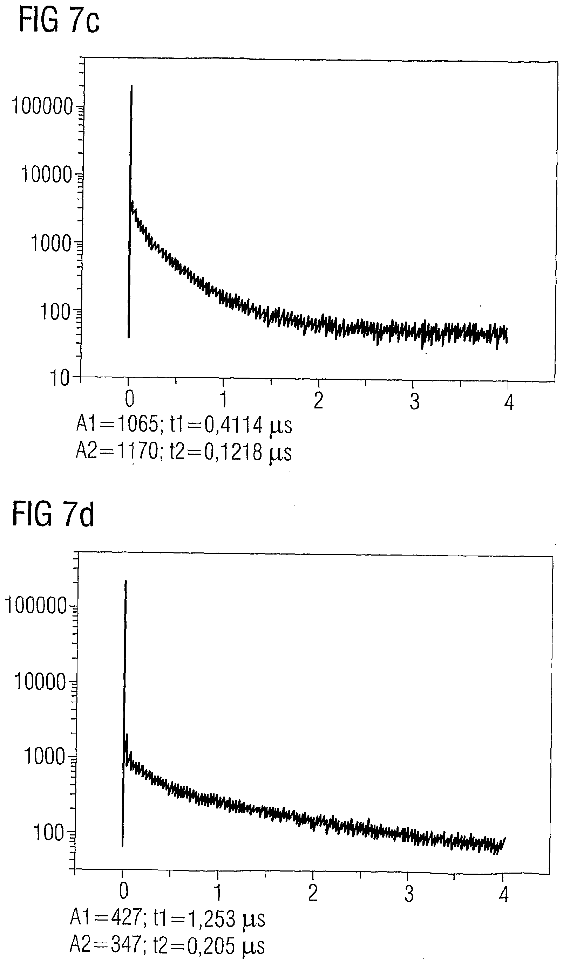

Die Figuren 6a bis 6d zeigen zeit- und wellenlängenaufgelöste Emissionsspektren.

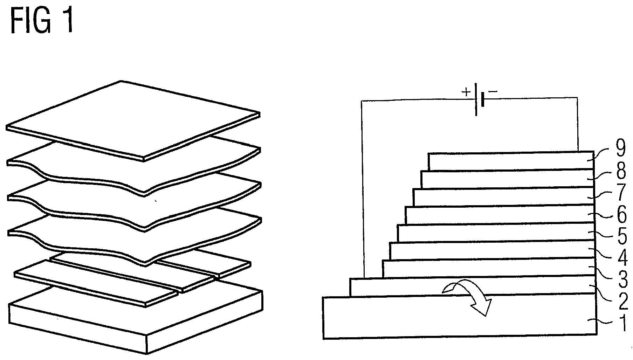

Die Figur 1 zeigt den schematisierten Schichtaufbau eines organischen selbstemittierenden Bauteils. Von unten nach oben ist folgender Schichtaufbau realisiert: Zu unterst befindet sich das Substrat 1, das beispielsweise transparent sein kann und auch aus Glas sein kann. Darauf befindet sich eine untere Elektrodenschicht 2, die beispielsweise ein transparentes leitendes Oxid wie Indium-Zinn-Oxid (ITO) sein kann. Die untere Elektrodenschicht kann dabei als Anode oder als Kathode fungieren. Über diese Elektrodenschicht 2 liegt eine Lochinjektionsschicht 3 über der wiederum eine Lochtransport-Schicht 4 angeordnet ist. Über der Lochtransport-Schicht 4 ist die organisch aktive Schicht, die Emissionsschicht 5, angeordnet. Es folgen auf die erste Emissionsschicht die weitere Emissionsschicht, die durch Exzitonen-Blockierschichten getrennt sind. Auf der einen Emissionsschicht liegt die lochblockierende Schicht 6, auf der die Elektronentransportschicht 7 und schließlich die Elektroneninjektionsschicht 8 mit angrenzender oberer Elektrode 9 angeordnet sind. Die obere Elektrode 9 kann beispielsweise eine Metallelektrode oder eine weitere transparente Elektrode, zum Beispiel aus einem der vorstehend genannten transparenten leitenden Oxide sein.

Bei Anlegen einer Spannung zwischen oberer und unterer Elektrode fließt Strom durch das Bauteil und in der organisch aktiven Schicht werden Photonen freigesetzt, die in Form von Licht über die transparente Elektrode beziehungsweise die transparenten Elektroden das Bauteil verlassen.

In der Emissionsschicht 5 sind erfindungsgemäß in einer Matrix ein oder mehrere Exzitonenfänger und ein oder mehrere strahlungsemittierende Emitter (letztere jeweils in niedriger Konzentration) vorgesehen.

Die Herstellung eines derartigen strahlungsemittierenden Bauelements kann zum Beispiel folgendermaßen erfolgen: Mittels HF-Sputtern wird zunächst eine ITO-Schicht als Anode auf einer Glasplatte abgeschieden. Zur Abscheidung der weiteren funktionellen Schichten wird dieses Substrat in einen Rezipienten eingebracht; dieser enthält mehrere Quellen, in denen organisches Material (insbesondere zur Verwendung als Exzitonenfänger sowie zur Verwendung als strahlungsemittierender Emitter) zur Herstellung der einzelnen funktionellen Schichten der strahlungsemittierenden Vorrichtung verdampft werden kann. Ferner werden eine oder mehrere Quellen für die Zuführung von einem oder mehreren verschiedenen Matrixmaterialien vorgesehen. Zur Ausbildung einer Lochinjektionsschicht wird aus einer Quelle mit Matrixmaterial und einer Quelle mit einem P-Dotanden gemeinsam auf der Glasplatte, auf der bereits die Anode vorliegt, abgeschieden. Entsprechend erfolgt die gemeinsame Abscheidung von Dotand und Matrixmaterial für die Lochtransport-Schicht. Anschließend erfolgt die gemeinsame Abscheidung eines Matrixmaterial, die zur erfindungsgemäßen Emitterschicht führt. Hierfür werden ein Matrixmaterial, der Exzitonenfänger und das mindestens eine strahlungsemittierende Emittermaterial gemeinsam abgeschieden. Die Abscheidung weiterer enthaltener Schichten wie Blockierschicht, Elektronentransportschicht und Elektroneninjektionsschicht erfolgt analog. Abschließend wird eine Aluminiumschicht als reflektierende Elektrode gebildet. Alternativ können (abgesehen von den Elektrodenschichten) die verschiedenen funktionellen Schichten auch mittels eines Nassprozesses (z.B. Spincoating) aufgebracht werden, dies kann insbesondere sinnvoll sein, wenn die aufzubringende Schicht ein Polymer enthält. Weiterhin können auch die zuerst aufgebrachten Schichten mittels eines Nassprozesses und alle darauf angeordneten Schichten mittels Aufdampfen.

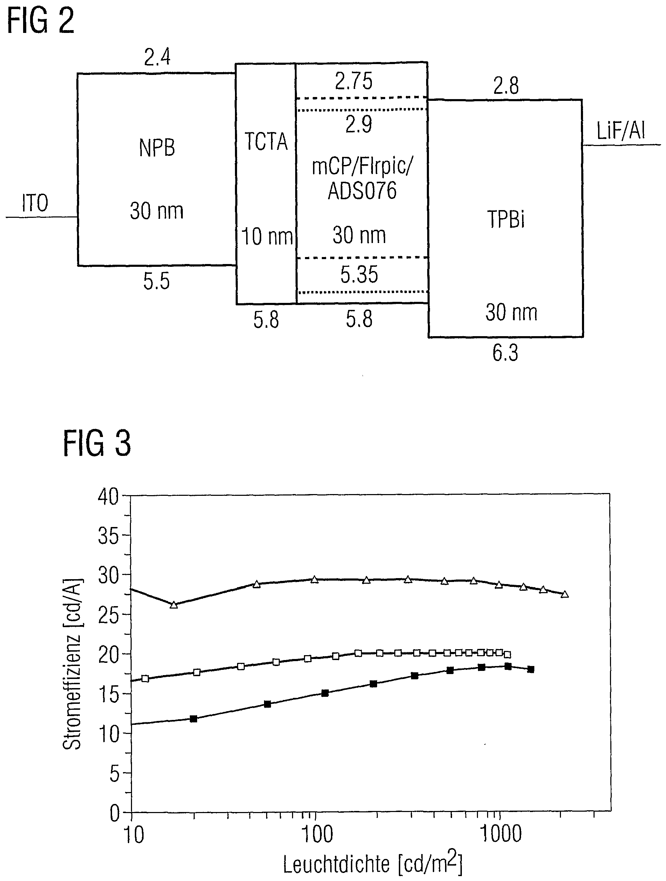

Im Folgenden wird ein Ausführungsbeispiel zur Herstellung einer OLED, die rotes Licht emittiert, angegeben (nicht Teil dieser Erfindung). Die schematische Struktur dieser rot emittierenden OLED ist in Figur 2 abgebildet.

Die rotes Licht emittierende OLED weist eine Lochtransport-Schicht aus NPB und eine Elektronentransportschicht aus TPBi, die jeweils 30 nm dick sind, auf. Auf der Lochtransport-Schicht ist eine Exzitonen-Blockierschicht aus TCTA angeordnet, um einen Transfer der Exzitonen aus der Emissionsschicht auf die weniger effiziente Lochtransport-Schicht zu vermeiden. Auch das auf der Kathode angeordnete TPBi fungiert als Blockierschicht für Exzitonen. Die Emissionsschicht selbst besteht aus dem Matrixmaterial mCP, in das der rot phosphoreszierende Emitter Ir(MDQ)₂(acac), auch ADS 076 genannt (Energienieveaus in Fig. 2 durch Punkte gekennzeichnet), und der hellblau phosphoreszierende Exzitonenfänger FIrpic (Energienieveaus in Fig. 2 durch Quadrate gekennzeichnet) eingebracht sind. Aufgrund der Triplettniveaus der Moleküle führt dies dazu, dass nach der Bildung eines Exzitons auf dem Matrixmaterial dieses auf den Exzitonenfänger und bei passender Konzentration auf ADS 076 übertragen wird. Der Exzitonenfänger liegt daher beispielsweise in einer Konzentration von 20 Gew.-% vor, was neben einer guten direkten Exzitonenbildung auf dem Dotierstoff zu einem sehr guten Transfer auf dem Matrixmaterial gebildeten Exzitonen führt. Des Weiteren können die Exzitonen aufgrund der hohen Konzentration gut über die Exzitonenfänger-Moleküle zu dem Emittermaterial diffundieren und dort übertragen werden. Aufgrund der Lage des LUMOs des Exzitonenfängers FIrpic in Bezug auf das LUMO der Elektronentransportschicht findet auch eine sehr gute Elektroneninjektion und wegen der guten Elektronenleitfähigkeit des Exzitonenfängers außerdem ein sehr guter Elektronentransport statt. Dies führt zu einer deutlichen Verbesserung der Stromeffizienz.

Das HOMO eines Materials kann mittels Photoelektronenspektroskopie bestimmt werden. Die Bandlücke, also der energetische Unterschied zwischen HOMO und LUMO kann mittels Spektroskopie ermittelt werden, bei der die Wellenlänge des emittierten Lichts gemessen wird und daraus die entstandenen Exzitonen und die Bandlücke berechnet wird. Das Energieniveau des LUMO wird dann aus dem ermittelten HOMO und der Bandlücke berechnet.

Figur 3 zeigt die verbesserte Stromeffizienz einer Emitterschicht mit mCP als Matrixmaterial, 20 Gew.-% FIrpic und 2 Gew.-% ADS 076 (obere Kurve - Dreiecke) gegenüber einer Schicht die als Matrixmaterial ebenfalls mCP und nur 2 Gew.-% ADS 076 (mittlere Kurve - ungefüllte Quadrate) beziehungsweise mCP mit nur 20 Gew.-% FIrpic (untere Kurve - gefüllte Quadrate) enthält.

In der nachfolgenden Tabelle werden die Performance-Daten der Vorrichtung mit Emitterschichten verglichen, die entweder nur den roten Emitter ADS 076 oder nur den Exzitonenfänger FIrpic enthalten angegeben:

| Konzentration | Stromstärke [mA/ cm²] | Leucht-dichte [cd/m²] | Spannung [v] | Stromeffizienz [cd/A] | Leistungseffizienz [lm/w] | externe Quanteneffizienz [ηₑₓₜ] |
|---|---|---|---|---|---|---|
| 20 Gew.-% FIrpic in mCP | 2,5 | 391 | 5,1 | 17,3 | 10,7 | 6,4% |
| 2 Gew.-% ADS 076 in mCP | 2,5 | 475 | 7,5 | 20,3 | 8,5 | 10,2% |
| 20 Gew.-% FIrpic + 2 Gew.-% ADS 076 in mCP | 2,5 | 654 | 5,5 | 28,9 | 16,5 | 14,7% |

Anhand des bei 5mA/m² gemessenen Elektrolumineszenz-Spektrums in Figur 4 erkennt man, dass durch Beimischung von 20 Gew.-% des Exzitonenfängers FIrpic zu 2% des roten Emitters ADS 076 ein sehr guter Energietransfer vom Exzitonenfänger auf den roten Emitter erfolgt. Das Spektrum (ungefüllte Quadrate) ist bis auf einen kleinen verbleibenden FIrpic Peak nahezu identisch mit demjenigen der reinen Schicht von mCP mit 2% ADS 076 (Dreiecke). Eine mCP-Schicht, die nur (20 Gew.-%) FIrpic enthält zeigt dagegen eine deutliche Emission im blauen Spektralbereich (gefüllte Quadrate).Diese Beobachtung ist auch im wesentlichen unabhängig von der Stromdichte, bei der gemessen wird. Die Figuren 5a-c zeigen die Emissionsspektren für 20 Gew.-% FIrpic in mCP (Figur 5a) 2 Gew.-% Ir (MDQ)₂ (acac) in mCP (Figur 5b) und 20 Gew.-% FIrpic sowie 2 Gew.-% Ir(MDQ)₂ (acac)in mCP (Figur 5c) bei Stromdichten von 0,5 mA/cm² bis 8,75 mA/cm². Diese sowie die vorstehenden und nachfolgenden Messwerte wurden mit einem Spektrometer des Typs Photo research PR 650 erhalten.

Die CIE-Koordinaten des emittierten Lichts für ein mCP mit rotem Emitter Ir(MDQ)₂(acac) und für mCP mit rotem Emitter Ir(MDQ)₂ (acac) und Exzitonenfänger FIrpic sind im Wesentlichen unverändert:

| Konzentration | Stromstärke [mA/ cm²] | CIE-Koordinate x | CIE-Koordinate y | externe Quanteneffizienz [ηₑₓₜ] |
|---|---|---|---|---|
| 20 Gew.-% FIrpic in mCP | 2,5 | 0,193 | 0,415 | 6,4% |
| 2 Gew.-% Ir(MDQ)₂ (acac)in mCP | 2,5 | 0,594 | 0,395 | 10,2% |
| 20 Gew.-% FIrpic + 2 Gew.-% Ir(MDQ)₂ (acac) in mCP | 2,5 | 0,591 | 0,392 | 14,7% |
| 20 Gew.-% FIrpic + 5 Gew.-% Ir(MDQ)₂ (acac) in mCP | 2,5 | 0,623 | 0,375 | 18,1% |

In Figur 5 erkennt man, dass die Beimischung auch eine verbesserte Injektion und einen verbesserten Transport über die FIrpic-Moleküle hervorruft, wodurch eine deutlich steilere Stromspannungskurve entsteht und geringere Betriebsspannungen benötigt werden (ungefüllte Quadrate). Diese sind ähnlich gut wie diejenigen mit 20 Gew.-% FIrpic ohne ADS 076 (gefüllte Quadrate), was zeigt, dass der Elektronentransport in der gemischten Schicht durch das Einbringen des Exzitonenfängers verbessert wird. Die Ursache für die in Figur 3 gezeigte Verbesserung der Stromeffizienz ist darin zu sehen, dass durch die höhere Konzentration des FIrpic mehr Exzitonen auf dem Exzitonenfänger gebildet werden und dann auf die Emitter-Moleküle übertragen werden. Da ADS 076 in geringer Konzentration vorliegt und der Transport vom FIrpic auf das ADS 076 sehr effizient und schnell vonstatten geht, erreicht man hierdurch, dass bei geringen Konzentrationsquentschingeffekten ein guter Transfer von Exzitonen auf den gewünschten Emitter erfolgt. Deshalb ergibt sich eine Erhöhung der Stromeffizienz.

Figur 6a bis 6d zeigt die Zerfallszeiten von Ir(ppy) und ADS 076 in PMMA als Matrix. Figur 6a zeigt die Zerfallszeit von 5 Gew.-% Ir(ppy)₃. Gemessen wird hierbei das Emissionsmaximum bei 510 nm. Es ergibt sich eine Halbwertszeit von 1,0 ms. Figur 6b zeigt für eine Probe mit 1 Gew.-% ADS 076 in PMMA die Zerfallszeit für das Emissionsmaximum bei 595 nm. Die Halbwertszeit beträgt 1,4 µs.Die Figuren 6c und 6d zeigen eine Emitterschicht mit 1 Gew.-% ADS 076 und 5 Gew.-% Ir(ppy)₃ in PMMA. Figur 6c zeigt die Zerfallszeit für das Emissionsmaximum des Exzitonenfängers bei 510 nm. Es ergibt sich eine Halbwertszeit von 0,4 µs, die nur noch 33% der Halbwertszeit für eine Probe, die nur das Matrixmaterial und den Exzitonenfänger enthält, beträgt. Figur 6d zeigt das Spektrum für das Emissionsmaximum von ADS 076 bei 595 nm; hier ergibt sich eine Halbwertszeit von 1,3 µsec, die gegenüber der einer Probe, die nur PMMA und ADS 076 enthält, kaum verändert ist. Die Messung der Halbwertszeiten erfolgt gemäß V. O'Connor, D. Phillips, "Time-Correleated single photon counting" (Academic Press, London 1987).

Die Erfindung ist nicht durch die Beschreibung anhand der Ausführungsbeispiele beschränkt.

## Patentansprüche

1. Strahlungsemittierende Vorrichtung aufweisend:
- ein Substrat (1);
- eine erste Elektrode (2) und eine zweite Elektrode (9),
- wenigstens eine zwischen der ersten und zweiten Elektrode angeordnete erste Emitterschicht (5),
- wobei die erste Emitterschicht ein Matrixmaterial und 0,5 - 5 Gew.-% eines ersten strahlungsemittierenden Emitters umfasst,
- wobei ein erster phosphoreszenter Exzitonenfänger, der ein Emissionsmaximum bei einer kürzeren Wellenlänge als der erste strahlungsemittierende Emitter aufweist, in einem Konzentrationsbereich von 5-30 Gew.-% derart beigemischt ist, wobei der Gewichtsanteil des ersten Exzitonenfängers höher ist als der des ersten strahlungsemittierenden Emitters,
- so dass Excitonen vom ersten Exzitonenfänger auf das erste Emittermaterial übertragen werden, wobei die Stromeffizienz der ersten Emitterschicht gegenüber der einer Emitterschicht ohne Exzitonenfänger um mindestens 10% erhöht ist,
- und wobei die Intensität der normalisierten Emission des Emissionsmaximums des ersten Exzitonenfängers in der ersten Emitterschicht maximal 5% der Intensität des Emissionsmaximums des ersten strahlungsemittierenden Emitters beträgt, **dadurch gekennzeichnet, dass**
- eine weitere Emitterschicht vorhanden ist, die einen zweiten strahlungsemittierenden Emitter sowie einen zweiten Exzitonenfänger enthält, und
- zwischen der ersten Emitterschicht und der weiteren Emitterschicht eine Blockierschicht zum Blockieren von Exzitonen vorhanden ist.

2. Strahlungsemittierende Vorrichtung nach dem vorhergehenden Anspruch, wobei der erste strahlungsemittierende Emitter ein phosphoreszenter Emitter ist.

3. Strahlungsemittierende Vorrichtung nach einem der vorhergehenden Ansprüche, wobei zwischen Elektrode und Emitterschicht eine Elektronentransportschicht angeordnet ist und das LUMO des ersten Exzitonenfängers niedriger liegt als das der Elektronentransportschicht.

4. Strahlungsemittierende Vorrichtung nach dem vorhergehenden Anspruch, wobei die Differenz der Emissionsmaxima zwischen dem ersten phosphoreszenten Exzitonenfänger und dem ersten strahlungsemittierenden Emitter mindestens 15 nm beträgt.

5. Strahlungsemittierende Vorrichtung nach einem der vorhergehenden Ansprüche, wobei die Intensität der normalisierten Emission des Emissionsmaximums des ersten Exzitonenfängers in der ersten Emitterschicht maximal 10% der normalisierten Emission des Emissionsmaximums des Exzitonenfängers in einer Schicht, die aus dem Matrixmaterial und dem Exzitonenfänger besteht, beträgt.

6. Strahlungsemittierende Vorrichtung nach einem der vorhergehenden Ansprüche, wobei in der ersten Emitterschicht (5) die Exzitonenlebensdauer auf dem ersten strahlungsemittierenden Emitter länger ist als die auf dem Exzitonenfänger.

7. Strahlungsemittierende Vorrichtung nach einem der vorhergehenden Ansprüche, wobei die externe Quanteneffizienz ηₑₓₜ der ersten Emitterschicht (5) gegenüber der einer Emitterschicht ohne Exzitonenfänger um mindestens 20% erhöht ist.

8. Strahlungsemittierende Vorrichtung nach einem der vorhergehenden Ansprüche, wobei die Photolumineszenzquantenausbeute des ersten strahlungsemittierenden Emitters größer ist als die des Exzitonenfängers.

9. Strahlungsemittierende Vorrichtung nach einem der vorhergehenden Ansprüche, wobei das LUMO des ersten strahlungsemittierenden Emitters höher liegt als das der Matrix und/oder des ersten Exzitonenfängers.

10. Strahlungsemittierende Vorrichtung nach einem der vorhergehenden Ansprüche, wobei die Schichtdicke der ersten Emitterschicht (5) 10 bis 40 nm beträgt.

11. Strahlungsemittierende Vorrichtung nach einem der vorhergehenden Ansprüche, wobei durch eine Überlagerung der durch die erste Emitterschicht (5) und die zumindest eine weitere Emitterschicht emittierten Strahlung Weißlicht emittiert wird.

## Claims

1. Radiation emitting device, having:
- a substrate (1);
- a first electrode (2) and a second electrode (9),
- at least a first emitter layer (5) arranged between the first and second electrode,
- wherein the first emitter layer comprises a matrix material and 0.5 - 5 % by weight of a first radiation emitting emitter,
- wherein a first phosphorescent exciton trap having an emission maximum at a shorter wavelength than the first radiation emitting emitter is admixed in a concentration range of 5 - 30% by weight such that the weight fraction of the first exciton trap is higher than that of the first radiation emitting emitter,
- so that excitons are transferred from the first exciton trap to the first emitter material, wherein the current efficiency of the first emitter layer is increased by at least 10% compared with that of an emitter layer without exciton trap,
- and wherein the intensity of the normalized emission of the emission maximum of the first exciton trap in the first emitter layer is at most 5% of the intensity of the emission maximum of the first radiation emitting emitter, **characterized in that**
- there is a further emitter layer comprising a second radiation emitting emitter and a second exciton trap, and
- a blocking layer for blocking excitons is present between the first emitter layer and the further emitter layer.

2. Radiation emitting device according to the preceding claim, wherein the first radiation emitting emitter is a phosphorescent emitter.

3. Radiation emitting device according to one of the preceding claims, wherein an electron transport layer is arranged between the electrode and the emitter layer and the LUMO of the first exciton trap is lower than that of the electron transport layer.

4. Radiation emitting device according to the preceding claim, wherein the difference in emission maxima between the first phosphorescent exciton trap and the first radiation emitting emitter is at least 15 nm.

5. Radiation emitting device according to one of the preceding claims, wherein intensity of the normalized emission of the emission maximum of the first exciton trap in the first emitter layer is at most 10% of the normalized emission of the emission maximum of the exciton trap in a layer consisting of the matrix material and the exciton trap.

6. Radiation emitting device according to one of the preceding claims, wherein in the first emitter layer (5) the lifetime of the exciton on the first radiation emitting emitter is longer than that on the exciton trap.

7. Radiation emitting device according to one of the preceding claims, wherein the external quantum efficiency ηₑₓₜ of the first emitter layer (5) is increased by at least 20% compared with that of an emitter layer without exciton trap.

8. Radiation emitting device according to one of the preceding claims, wherein the photoluminescence quantum yield of the first radiation emitting emitter is greater than that of the exciton trap.

9. Radiation emitting device according to any of the preceding claims, wherein the LUMO of the first radiation emitting emitter is higher than that of the matrix and/or the first exciton trap.

10. Radiation emitting device according to one of the preceding claims, wherein the layer thickness of the first emitter layer (5) is 10 to 40 nm.

11. Radiation emitting device according to one of the preceding claims, wherein white light is emitted by a superposition of the radiation emitted by the first emitter layer (5) and the at least one further emitter layer.

## Revendications

1. Dispositif émetteur de rayonnement comprennent:
- un substrat (1);
- une première électrode (2) et une deuxième électrode (9),
- au moins une première couche émettrice (5) disposée entre la première et la seconde électrode,
- dans laquelle la première couche émettrice comprend un matériau de matrice et 0,5 à 5 % en poids d'un premier émetteur émettant un rayonnement,
- dans laquelle un premier piège à exciton phosphorescent ayant un maximum d'émission à une longueur d'onde inférieure à celle de le premier émetteur émettant de rayonnement mélangé dans une plage de concentration de 5 à 30 % en poids de sorte que la fraction en poids du premier piège à exciton est supérieure à celle du premier émetteur émettant un rayonnement,
- de sorte que des excitons sont transférées du premier piège à exciton au premier matériau émetteur, dans lequel l'efficacité actuelle de la première couche émettrice est augmentée d'au moins 10 % par rapport à celle d'une couche émettrice sans piège à exciton,
- et dans laquelle l'intensité de l'émission normalisée du maximum d'émission du premier piège à exciton dans la première couche émettrice est d'au plus 5% de l'intensité du maximum d'émission du premier émetteur émettant de rayonnement, **caractérisé en ce que**
- il y a une autre couche émettrice comprenant un second émetteur émettant un rayonnement et un second piège à exciton, et
- une couche de blocage pour bloquer les excitons est présente entre la première couche émettrice et l'autre couche émettrice.

2. Dispositif émetteur de rayonnement selon la revendication précédente, dans lequel le premier émetteur émettant de rayonnement est un émetteur phosphorescent.

3. Dispositif émetteur de rayonnement selon l'une des revendications précédentes, dans lequel une couche de transport d'électrons est disposée entre l'électrode et la couche émettrice et le LUMO du premier piège à exciton est inférieur à celui de la couche de transport d'électrons.

4. Dispositif émetteur de rayonnement selon la revendication précédente, dans lequel la différence de maxima d'émission entre le premier piège à exciton phosphorescent et le premier émetteur émettant de rayonnement est d'au moins 15 nm.

5. Dispositif émetteur de rayonnement selon l'une des revendications précédentes, dans lequel l'intensité de l'émission normalisée du maximum d'émission du premier piège à exciton dans la première couche émettrice est d'au plus 10% de l'émission normalisée du maximum d'émission du piège à exciton dans une couche constituée par le matériau de matrice et le piège à exciton.

6. Dispositif émetteur de rayonnement selon l'une des revendications précédentes, dans lequel, dans la première couche émettrice (5), la durée de vie de des excitons du premier émetteur émettant de rayonnement est plus longue que celle du piège à exciton.

7. Dispositif émetteur de rayonnement selon l'une des revendications précédentes, dans lequel l'efficacité quantique externe ηₑₓₜ de la première couche émettrice (5) est augmentée d'au moins 20 % par rapport à celle d'une couche émettrice sans piège à exciton.

8. Dispositif émetteur de rayonnement selon l'une des revendications précédentes, dans lequel le rendement quantique de photoluminescence du premier émetteur émettant de rayonnement est supérieur à celui du piège à exciton.

9. Dispositif émetteur de rayonnement selon l'une quelconque des revendications précédentes, dans lequel le LUMO du premier émetteur émettant de rayonnement est supérieur à celui de la matrice et/ou du premier piège à exciton.

10. Dispositif émetteur de rayonnement selon l'une des revendications précédentes, dans lequel l'épaisseur de couche de la première couche émettrice (5) est de 10 à 40 nm.

11. Dispositif émetteur de rayonnement selon l'une des revendications précédentes, dans lequel la lumière blanche est émise par une superposition du rayonnement émis par la première couche émettrice (5) et la au moins une autre couche émettrice.
